# EUROPEAN PATENT APPLICATION

(11) **EP 4 583 651 A1**
(43) Date of publication of application: **09.07.2025**
(21) Application number: 24813091.6
(22) Date of filing: 05.11.2024
(51) Int. Cl.: H05K 7/20, H04M 1/03, H04M 1/02

(54) **ELECTRONIC DEVICE INCLUDING HEAT TRANSFER PART FORMING SOUND OUTPUT PASSAGE**

(30) Priority: 06.11.2023 KR 20230151524; 03.01.2024 KR 20240000952
(71) Applicant: Samsung Electronics Co., Ltd., Suwon-si, Gyeonggi-do 16677 (KR)
(72) Inventor: KIM, Sanguk, Suwon-si, Gyeonggi-do 16677 (KR); LEE, Seunghyuk, Suwon-si, Gyeonggi-do 16677 (KR); LEE, Chanwoo, Suwon-si, Gyeonggi-do 16677 (KR); JEKAL, Ha, Suwon-si, Gyeonggi-do 16677 (KR); HAN, Kihyuk, Suwon-si, Gyeonggi-do 16677 (KR); HWANG, Ryuwon, Suwon-si, Gyeonggi-do 16677 (KR)
(74) Representative: Nederlandsch Octrooibureau
(86) International application number: PCT/KR2024/017311
(87) International publication number: WO 2025/100904

(57) **Abstract**

An electronic device according to an embodiment of the disclosure may include a support bracket, a display disposed on the front surface of the support bracket, a printed circuit board disposed on the rear surface of the support bracket, a sound output module, an electronic component disposed on the printed circuit board and generating heat during operation, and a heat transfer unit disposed between the display and the support bracket and configured to transfer the heat generated from the electronic component. The heat transfer unit may be configured to provide a portion of a sound output passage through which sound generated from the sound output module passes.

## Description

### [Technical Field]

The disclosure relates to an electronic device including a heat transfer unit configured to provide a sound output passage.

### [Background Art]

An electronic device (e.g., a portable electronic device) may include a heating component (e.g., an application processor) that generates heat during operation and a heat transfer unit (e.g., a vapor chamber) to improve heat dissipation performance.

The heating component and the heat transfer unit of the electronic device may be disposed with a support interposed therebetween. Heat generated from the heating component may be transferred to the heat transfer unit via the support. The heat transfer unit may serve to diffuse heat transferred from the heating component of the electronic device to other areas of the electronic device.

The above information may be provided as a related art for the purpose of helping understanding of the disclosure. None of the foregoing content can be claimed as prior art related to this disclosure or used to determine prior art.

### [Disclosure of Invention]

### [Technical Problem]

The electronic device may include a sound output module configured to output sound and a sound output passage through which sound generated by the sound output module passes.

Because the display may be made of a relatively fragile material, the electronic device may include a plate provided separately from the display to define a sound output passage through which sound passes. For example, at least a portion of the sound output passage may be defined by a separate plate made of stainless steel. When a separate plate defines a portion of the sound output passage, the manufacturing cost of the electronic device may increase.

### [Solution to Problem]

An electronic device according to an embodiment of the disclosure may include a support bracket, a display, a printed circuit board, a sound output module, an electronic component, and a heat transfer unit.

In an embodiment, the display may be placed on the front surface of the support bracket.

In an embodiment, the printed circuit board may be placed on the rear surface of the support bracket.

In an embodiment, the electronic component may be placed on the printed circuit board and may generate heat during operation.

In an embodiment, the heat transfer unit may be disposed between the display and the support bracket, and may be configured to transfer heat generated from the electronic component.

In an embodiment, the heat transfer unit may be configured to provide a portion of the sound output passage through which sound generated from the sound output module passes.

An electronic device according to an embodiment of the disclosure may include a support bracket, a display, an electronic component, and a heat transfer unit.

In an embodiment, the heat transfer unit may include a plate and a flow space surrounded by the plate.

In an embodiment, at least a portion of the plate may provide a portion of a sound output passage through which sound is propagated.

### [Advantageous Effects of Invention]

In the electronic device according to an embodiment of the disclosure, the sound output passage through which the sound passes may be provided by extending a portion of the heat transfer unit.

The electronic device according to an embodiment of the disclosure does not require a separate plate to provide the sound output passage through which the sound passes. Thus, the manufacturing cost of the electronic device can be reduced, and the manufacturing process can be simplified because the sound output passage does not require a separate plate.

### [Brief Description of Drawings]

FIG. 1 is a block diagram of an electronic device according to an embodiment in a network environment.
FIG. 2 is a view illustrating an electronic device according to an embodiment of the disclosure.
FIG. 3 is a view illustrating an electronic device including a thermal diffusion member according to an embodiment of the disclosure.
FIG. 4 is a view illustrating an electronic device including a flow space according to an embodiment of the disclosure.
FIG. 5 is a view illustrating an electronic device including a support area according to an embodiment of the disclosure.
FIGS. 6A and 6B are views illustrating an electronic device including a sound output passage area defined by a first plate or a second plate according to an embodiment of the disclosure.
FIG. 7 is a view illustrating a support, a heat transfer unit, and a thermal diffusion member according to an embodiment of the disclosure.

### [Mode for the Invention]

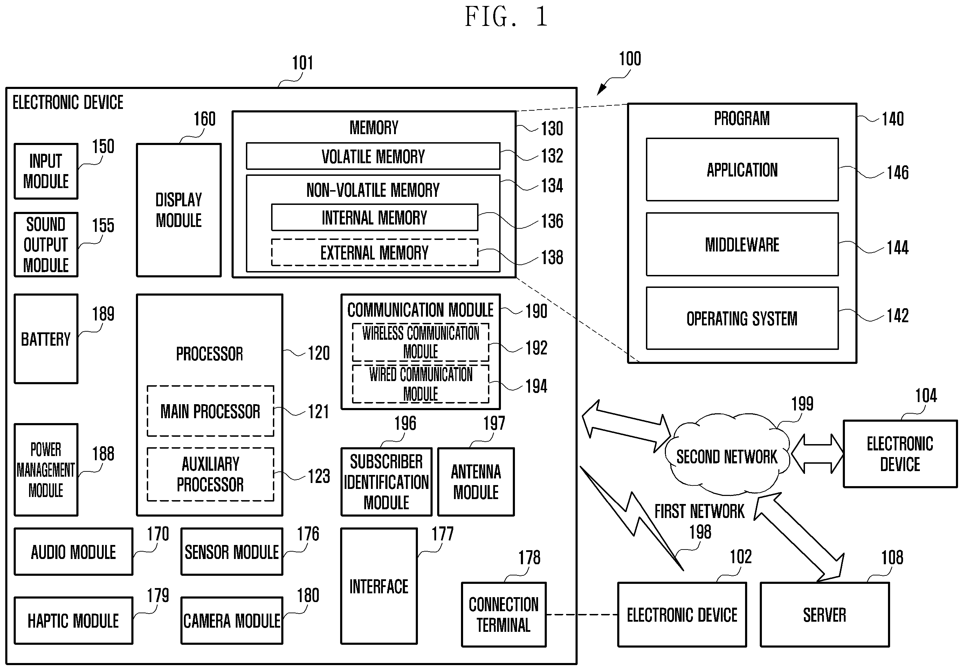

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

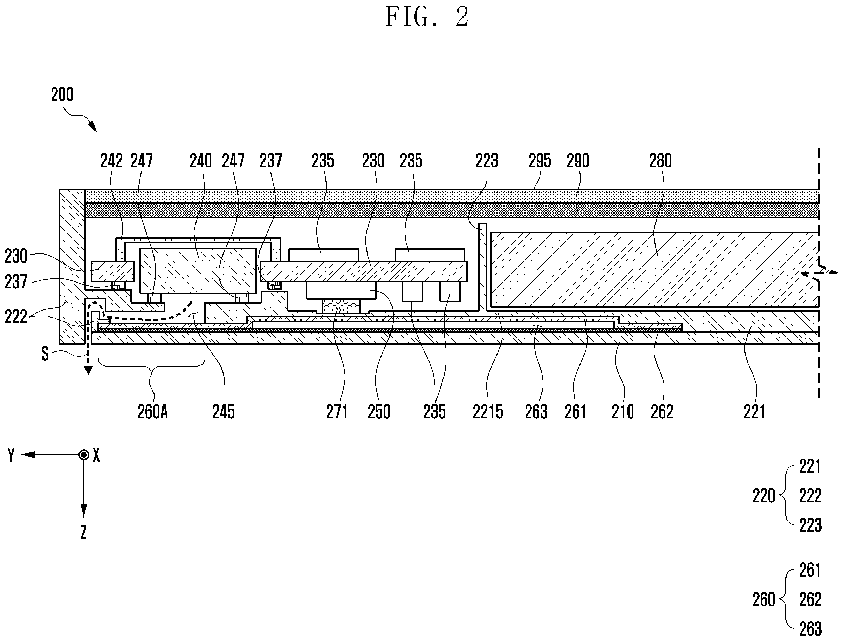

FIG. 2 is a view illustrating an electronic device 200 according to an embodiment of the disclosure.

The electronic device 200 of FIG. 2 may refer to the electronic device 101 of FIG. 1 or may include some of the components of the electronic device 101 of FIG. 1.

In describing the electronic device 200 according to an embodiment of the disclosure, the length direction of the electronic device 200 may refer to the Y-axis direction, and the height direction of the electronic device 200 may refer to the Z-axis direction. The width direction of the electronic device 200 may refer to the X-axis direction, which is a direction perpendicular to the length direction and the height direction.

The electronic device 200 according to an embodiment of the disclosure may include a display 210, a support 220, a printed circuit board 230, a sound output module 240, an electronic component 250, a heat transfer unit 260, a battery 280, a heat transfer material 271, a rear surface support 290, and/or a rear surface cover 295.

In an embodiment, the display 210 may refer to the display module 160 of FIG. 1 or may include at least a portion of the display module 160.

In an embodiment, the display 210 may visually provide information to the outside of the electronic device 101 (e.g., a user). The display 210 may include, for example, a display, a hologram device or a projector, and a control circuit for controlling the corresponding device. According to an embodiment, the display 210 may include a touch sensor configured to detect a touch or a pressure sensor configured to measure the intensity of force generated by the touch.

In an embodiment, the support 220 may include a support bracket 221, a distal end member 222, and/or a partition 223.

In an embodiment, the support bracket 221 may serve to support components (e.g., the display 210 and the battery 280) of the electronic device 200.

In an embodiment, the support bracket 221 may be a support member configured to support components of the electronic device 200.

In an embodiment, the distal end member 222 may be disposed to surround the distal end of electronic device 200. For example, the distal end member 222 may be disposed at the distal end of the electronic device 200 oriented in the +Y-axis direction. In an embodiment, the distal end member 222 may be manufactured using an injection molding process.

In an embodiment, one direction of the support bracket 221 may refer to the -Z-axis direction. The other direction of the support bracket 221 may refer to the +Z-axis direction.

In an embodiment, the front surface of the support bracket 221 may refer to the surface of the support bracket 221 oriented in the +Z-axis direction. In an embodiment, the rear surface of the support bracket 221 may refer to the surface of the support bracket 221 oriented in the - Z-axis direction.

In an embodiment, the printed circuit board 230 may be disposed in one direction (e.g., the -Z-axis direction) of the support bracket 221.

In an embodiment, the printed circuit board 230 may be disposed on the rear surface of the support bracket 221.

In an embodiment, the printed circuit board 230 may be connected to the support 220 via a first connection member 237. For example, the printed circuit board 230 may be connected to the support bracket 221 and the distal end member 222 via the first connection member 237 and supported by the support bracket 221 and the distal end member 222. In an embodiment, the first connection member 237 may include an adhesive material.

In an embodiment, the display 210 may be disposed on support bracket 221. For example, the display 210 may be disposed in the +Z-axis direction of the support bracket 221. The display 210 may be supported by at least a portion of the support bracket 221.

In an embodiment, the display 210 may be disposed on the front surface of the support bracket 221.

In an embodiment, the sound output module 240 may refer to the sound output module 155 of FIG. 1 or may include at least a portion of the sound output module 155.

In an embodiment, the sound output module 240 may output sound to the outside of the electronic device 101. The sound output module 240 may include, for example, a speaker or a receiver.

In an embodiment, the sound output module 240 may be electrically connected to the printed circuit board 230.

In an embodiment, the sound output module 240 may be disposed to be at least partially surrounded by the printed circuit board 230.

In an embodiment, at least a portion of the sound output module 240 may be surrounded by a shield can 242. The shield can 242 surrounds the sound output module 240 and may serve to shield noise.

In an embodiment, the sound output module 240 may be connected to the support 220 via a second connection member 247. For example, the sound output module 240 may be connected to the support bracket 221 and the distal end member 222 via the second connection member 247 and supported by the support bracket 221 and the distal end member 222. In an embodiment, the second connection member 247 may include an adhesive material.

In an embodiment, the electronic component 250 may be disposed on the printed circuit board 230. For example, the electronic component 250 may be disposed on one surface of the printed circuit board 230 (e.g., the surface of the printed circuit board 230 oriented in the +Z-axis direction).

In an embodiment, the electronic component 250 may include a processor.

In an embodiment, the electronic component 250 may be a heating component that generates heat during operation. For example, the electronic component 250 may be an application processor configured to control components of the electronic device 200 and perform various data processing or operations.

In an embodiment, the printed circuit board 230 may include at least one electronic device 235. The electronic device 235 may be disposed on one surface of the printed circuit board 230 (e.g., the surface of the printed circuit board 230 oriented in the +Z-axis direction) and/or the other surface opposite to the one surface. In an embodiment, the electronic device 235 may include a processor (e.g., the processor 120 in FIG. 1), memory (e.g., the memory 130 in FIG. 1), and/or an interface (e.g., the interface 177 in FIG. 1).

In an embodiment, the heat transfer unit 260 may be disposed in another direction (e.g., the +Z-axis direction) of the support part 2215 of the support bracket 221.

In an embodiment, the heat transfer unit 260 may be disposed between the display 210 and the support bracket 221. For example, the heat transfer unit 260 may be disposed between the display 210 and the support part 2215 of the support bracket 221. In an embodiment, the support bracket 221 may be disposed to cover the heat transfer unit 260 in the support part 2215.

In an embodiment, the heat transfer unit 260 may serve to diffuse heat generated from the electronic component 250 to other areas of the electronic device 200.

In an embodiment, the heat transfer unit 260 may serve to transfer heat generated from the electronic component 250 to other areas of the electronic device 200.

In an embodiment, the heat transfer unit 260 may include a heat pipe and/or a graphite sheet.

In an embodiment, the heat transfer material 271 may be disposed between the electronic component 250 and the heat transfer unit 260. The heat transfer material 271 may be in contact with the electronic component 250 on one surface (e.g., the surface of the heat transfer material 271 oriented in the negative Z-axis direction) and may be in contact with the heat transfer unit 260 on the other surface.

In an embodiment, heat generated from the electronic component 250 may be transferred to the support bracket 221 via the heat transfer material 271. The heat transferred to the support bracket 221 may be transferred to the heat transfer unit 260 disposed in contact with the support bracket 221.

In an embodiment, the heat transfer material 271 may include a thermal interface material (TIM). For example, the heat transfer material 271 may include a liquid or solid TIM.

In an embodiment, the battery 280 may be disposed in one direction (e.g., the -Z-axis direction) of the support bracket 221. In one embodiment, the battery 280 may supply power to at least one component of the electronic device 200. According to an embodiment, the battery 280 may include, for example, a non-rechargeable primary cell, a rechargeable secondary cell, or a fuel cell.

In an embodiment, the support part 220 may include a partition 223 extending in the height direction of the electronic device 200 (e.g., Z-axis direction).

In an embodiment, the partition 223 may extend from the support part 2215 of the support bracket 221 in the height direction of the electronic device 200.

In an embodiment, the partition 223 may define a space in which the battery 280 is disposed and allow the battery 280 to be disposed separately from other components of the electronic device 200.

In an embodiment, the battery 280 and the printed circuit board 230 may be arranged in different directions with respect to the partition 223. For example, the battery 280 may be disposed in the -Y-axis direction with respect to the partition 223, and the printed circuit board 230 may be disposed in the +Y-axis direction.

In an embodiment, the rear surface support 290 may be disposed in the opposite direction of the support 220. For example, the rear surface support 290 may be disposed in the -Z-axis direction with respect to the printed circuit board 230 and the battery 280.

In an embodiment, the rear surface cover 295 may be disposed on the rear surface support 290. The rear surface cover 295 may serve to protect the rear surface of the electronic device 200 (e.g., the surface of the electronic device 200 oriented in the -Z-axis direction).

In an embodiment, the sound output module 240, the electronic component 250, and the battery 280 may be arranged in that order along the length direction (e.g., the Y-axis direction) of the electronic device 200.

In an embodiment, the heat transfer unit 260 may extend from a position overlapping the sound output module 240 to a position overlapping the battery 280. For example, the heat transfer unit 260 may overlap the sound output module 240 and the battery 280 when viewed in the height direction of the electronic device 200 (e.g., the Z-axis direction).

In an embodiment, the heat transfer unit 260 may include a first plate 261, a second plate 262, and/or a flow space 263.

In an embodiment, the heat transfer unit 260 may refer to a vapor chamber.

In an embodiment, the heat transfer unit 260 may include a vapor chamber. In an embodiment, a vapor chamber may include a first plate 261, a second plate 262, and/or a flow space 263.

In an embodiment, the vapor chamber may include a rear surface that defines a portion of the sound output passage 245 and a front surface where the display 210 is disposed.

In an embodiment, the rear surface of the vapor chamber may refer to the rear surface of the first plate 261 or the second plate 262 The front surface of the vapor chamber may refer to the front surface of the first plate 261 or the second plate 262.

In an embodiment, the first plate 261 may be in contact with the support bracket 221. For example, the first plate 261 may extend while being in contact with the support part 2215 of the support bracket 221.

In an embodiment, the first plate 261 may extend along the length direction of the electronic device 200 (e.g., the Y-axis direction). In an embodiment, the first plate 261 may extend while being at least partially bent.

In an embodiment, the second plate 262 may be disposed in a direction from the first plate 261 toward the display 210 (e.g., the +Z-axis direction).

In an embodiment, the second plate 262 may be coupled with the first plate 261. In an embodiment, the second plate 262 may extend along the length direction of the electronic device 200 (e.g., the Y-axis direction).

In an embodiment, the first plate 261 and the second plate 262 may contain a material with high thermal conductivity. For example, the first plate 261 and the second plate 262 may contain a metal material with high thermal conductivity.

In an embodiment, the first plate 261 may be a metal plate containing a metal material.

In an embodiment, the second plate 262 may be a metal plate containing a metal material.

In an embodiment, the flow space 263 may be defined in at least a portion of the space between the first plate 261 and the second plate 262. For example, the first plate 261 and/or the second plate 262 may extend while being at least partially bent so that the flow space 263 may be provided between the first plate 261 and the second plate 262.

In an embodiment, a diffusion material may be disposed within the flow space 263. The diffusion material is convertible into a liquid state or a gaseous state. The diffusion material may serve to diffuse the heat transferred from the heat transfer unit 260 throughout the electronic device 200.

In an embodiment, the amount of diffusion material disposed within the flow space 263 may vary in proportion to the size of the flow space 263.

In an embodiment, the flow space 263 may be completely sealed from the outside. For example, the first plate 261 and the second plate 262 may be coupled to define the flow space 263 that is completely sealed from the outside.

In an embodiment, the sound S generated from the sound output module 240 may be propagated along the sound output passage 245. The sound S may pass through the sound output passage 245 to be transmitted to the outside of the electronic device 200.

In an embodiment, the heat transfer unit 260 may include a sound output passage area 260A that defines the sound output passage 245. For example, referring to FIG. 2, the sound output passage area 260A of the heat transfer unit 260 extends in a direction toward the distal end member 222 (e.g., the +Y-axis direction) to surround at least a portion of the sound output passage 245.

In an embodiment, in the process of manufacturing the electronic device 200, a surface treatment process may be performed on the sound output passage area 260A of the heat transfer unit 260. For example, the surface of the sound output passage area 260A of the heat transfer unit 260 may be formed smoothly through a surface treatment process. The surface of the sound output passage area 260A formed smoothly may be more advantageous for the sound S to be propagated without loss in the sound output passage 245 because a smooth surface results in less absorption and reflection of sound energy as compared with a rough or porous surface.

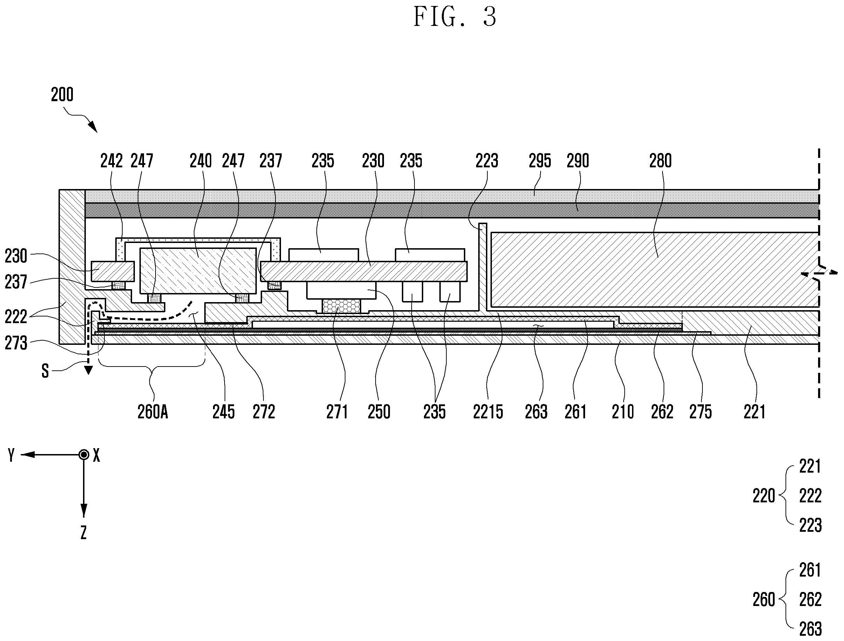

FIG. 3 is a view illustrating an electronic device 200 including a thermal diffusion member 275 according to an embodiment of the disclosure.

In describing the electronic device 200 illustrated in FIG. 3, a description of configurations that are substantially the same as those of the electronic device 200 illustrated in FIG. 2 may be omitted.

In an embodiment, the electronic device 200 may include a thermal diffusion member 275. In an embodiment, the thermal diffusion member 275 may be disposed between the heat transfer unit 260 and the display 210.

In an embodiment, the thermal diffusion member 275 may include a material with high thermal conductivity.

In an embodiment, the thermal diffusion member 275 may refer to a graphite sheet. In an embodiment, the heat diffusion member 275 may include a graphite sheet.

In an embodiment, the thermal diffusion member 275 is disposed on the heat transfer unit 260 to further improve the thermal diffusion effect of the heat transfer unit 260. For example, when the electronic device 200 includes the thermal diffusion member 275, the heat transfer unit 260 may transfer the heat generated in the electronic component 250 to diffusion member 275 which in turn diffuses the heat to other areas of the electronic device 200.

In an embodiment, the electronic device 200 may include adhesive members 272 and 273. The adhesive members 272 and 273 may be disposed between the heat transfer unit 260 and the support unit 220.

In an embodiment, the adhesive members 272 and 273 may refer to an adhesive material. In an embodiment, the adhesive members 272 and 273 may contain an adhesive material.

In an embodiment, the heat transfer unit 260 is at least partially coupled to the support 220 via the adhesive members 272 and 273. For example, the heat transfer unit 260 may be coupled to the support bracket 221 of the support unit 220 via the first adhesive member 272. The heat transfer unit 260 may be coupled to the distal end member 222 of the support unit 220 via a second adhesive member 273 at the distal end.

In an embodiment, the adhesive members 272 and 273 may serve to seal the space between the heat transfer unit 260 and the support unit 220.

In an embodiment, since the first adhesive member 272 and the second adhesive member 273 seal the space between the heat transfer unit 260 and the support unit 220, the sound output passage 245 may extend in a state of being completely isolated from the outside. For example, the sound output passage 245 may extend toward an open portion of the distal end in the state of being completely isolated from the outside.

In an embodiment, the sound output passage 245 extends toward the open portion of the distal end of electronic device 200. The sound output passage is completely isolated from the outside, which is advantageous for sound S to be propagated along the sound output passage 245 and enables the performance of the sound output module 240 to be improved because the sound energy in the sound output passage 245 is not subject to outside interferences.

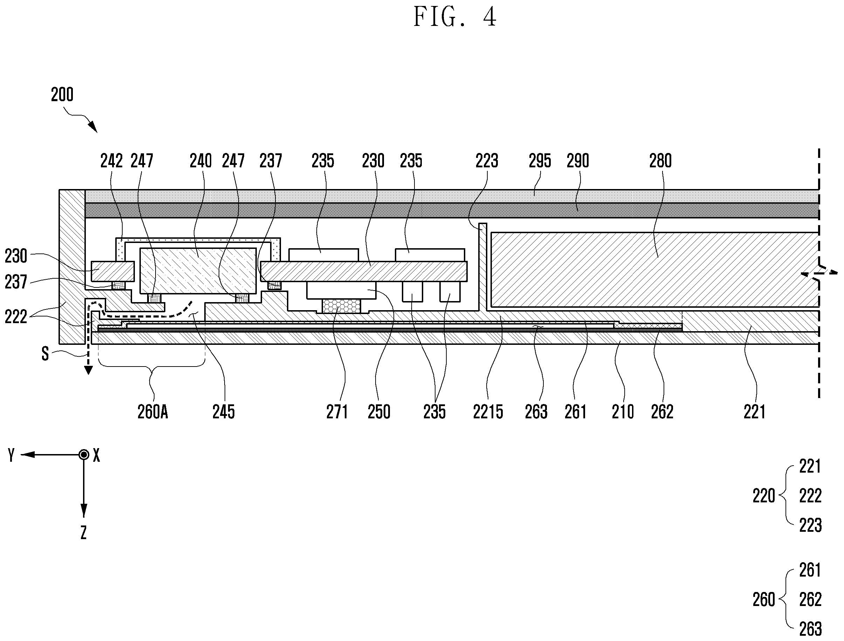

FIG. 4 is a view illustrating an electronic device 200 including a flow space 263 according to an embodiment of the disclosure.

In describing the electronic device 200 illustrated in FIG. 4, a description of configurations that are substantially the same as those of the electronic device 200 illustrated in FIG. 2 may be omitted.

In an embodiment, at least a portion the flow space 263 may be disposed at a position overlapping the sound output passage 245. For example, a portion of the flow space 263 may overlap the sound output passage 245 when viewed in the height direction of the electronic device 200 (e.g., the Z-axis direction). The flow space 263 may be provided in the sound output passage area 260A of the heat transfer unit 260, where at least a portion of the flow space 263 overlaps the sound output passage 245.

In an embodiment, the flow space 263 of the heat transfer unit 260 may extend along the length direction of the electronic device 200 (e.g., the Y-axis direction). For example, the flow space 263 may extend from a position overlapping the sound output passage 245 to a position overlapping the battery 280 along the length direction of the electronic device 200. The flow space 263 may overlap the sound output passage 245 and the battery 280 when viewed in the height direction of the electronic device 200 (e.g., Z-axis direction).

In an embodiment, as the flow space 263 is formed larger, the heat transfer effect of the heat transfer unit 260 can be improved. For example, as the flow space 263 is formed larger, the diffusion material inside the flow space 263 can easily be moved to other areas of the electronic device 200, and thus the heat transfer effect of the heat transfer unit 260 can be improved.

In an embodiment, since the flow space 263 extends from a position overlapping the battery 280 to a position overlapping the sound output passage 245, the heat transfer effect of the heat transfer unit 260 can be improved because of an increase in flow space 263.

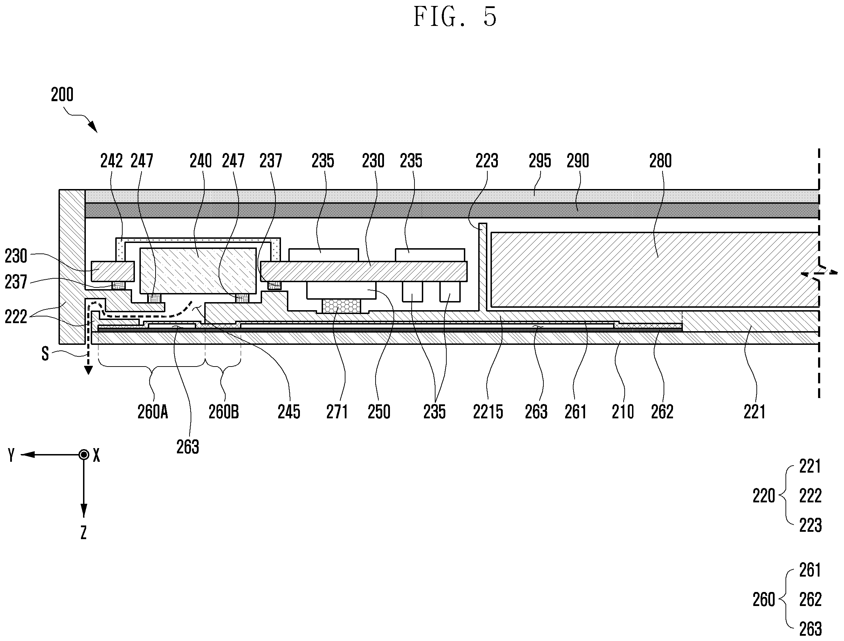

FIG. 5 is a view illustrating an electronic device 200 including a support area 260B according to an embodiment of the disclosure.

In describing the electronic device 200 illustrated in FIG. 5, a description of configurations that are substantially the same as those of the electronic device 200 illustrated in FIG. 2 may be omitted.

In an embodiment, the heat transfer unit 260 may include a support area 260B. The support area 260B may be an area where a portion of the heat transfer unit 260 is supported by the support bracket 221. In an embodiment, the support area 260B may be an area located between flow spaces 263.

In an embodiment, the support area 260B may be an area where the first plate 261 and the second plate 262 are in contact with each other.

In an embodiment, the support area 260B of the heat transfer unit 260 may be formed in a shape corresponding to the support bracket 221. For example, referring to FIG. 5, when a portion of the support bracket 221 protrudes in the +Z-axis direction, the support area 260B disposed at a corresponding position may be formed in a shape in which a portion of the heat transfer unit 260 is concave in the +Z-axis direction.

In an embodiment, the heat transfer unit 260 may be in contact with the support bracket 221 in the support area 260B. For example, a portion of the first plate 261 of the heat transfer unit 260 may be formed in a shape concave in the +Z-axis direction to be in contact with a portion of the support bracket 221 protruding in the +Z-axis direction.

In an embodiment, the heat transfer unit 260 may not include the flow space 263 in the support area 260B. For example, the heat transfer member 260 may have a first plate 261 and a second plate 262 which are coupled to be in contact with each other in the support area 260B and may not include the flow space 263.

In an embodiment, the support area 260B of the electronic device 200 may be formed only in a portion of the electronic device 200. For example, the electronic device 200 may include a support area 260B in the form illustrated in FIG. 5 in a portion of a cross section perpendicular to the width direction of the electronic device 200 (e.g., the X-axis direction), and in the remaining portion of the cross section perpendicular to the width direction of the electronic device 200, the electronic device 200 may include the flow space 263 in the form illustrated in FIG. 4 without the support area 260B. Accordingly, the flow spaces 263, which are located in the -Y-axis direction and the +Y-axis direction, respectively, with respect to the support area 260B, may be connected to each other in a portion of the electronic device 200.

In an embodiment, since the first plate 261 and the second plate 262 of the heat transfer unit 260 are coupled in contact with each other in the support area 260B, the heat transfer unit 260 can be stably supported by the support bracket 221. For example, the heat transfer unit 260 does not include an empty space (e.g., the flow space 263) between the first plate 261 and the second plate 262 in the support area 260B, which may be more advantageous for the bracket 221 to withstand the load applied to the heat transfer unit 260.

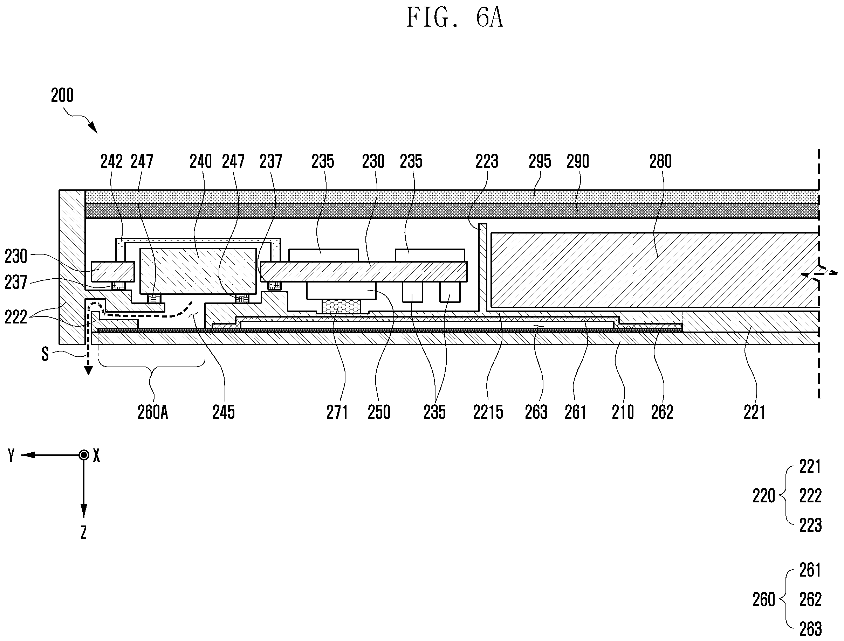

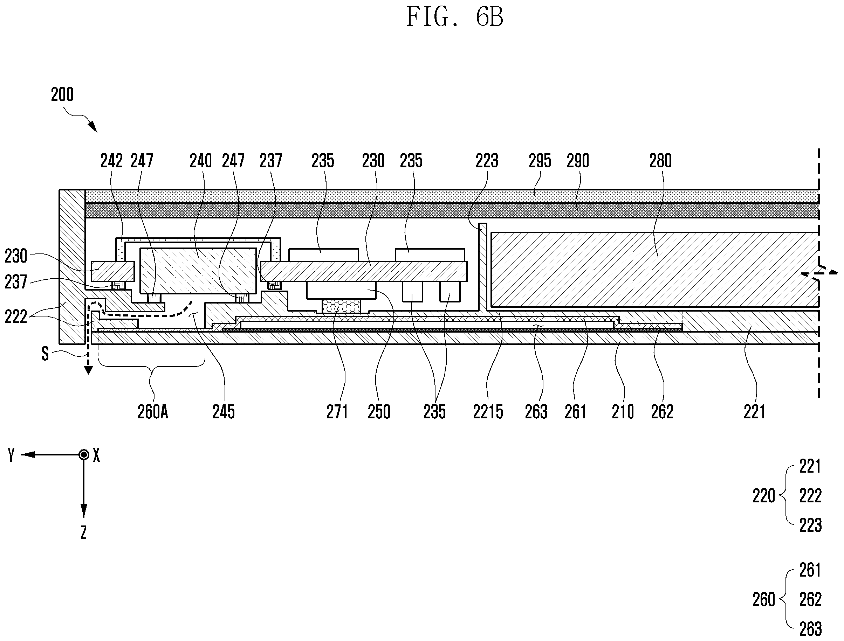

FIGS. 6A and 6B are views illustrating an electronic device 200 including a sound output passage area 260A defined by a first plate 261 or a second plate 262 according to an embodiment of the disclosure.

In describing the electronic device 200 illustrated in FIGS. 6A and 6B, a description of configurations that are substantially the same as those of the electronic device 200 illustrated in FIG. 2 may be omitted.

FIG. 6A is a view illustrating a sound output passage area 260A defined by the second plate 262 according to an embodiment. FIG. 6B is a view illustrating the sound output passage area 260A defined by the first plate 261 according to an embodiment.

In an embodiment, the sound output passage area 260A may be defined by one plate instead of two plates 261 and 262. For example, referring to FIG. 6A, the sound output passage area 260A according to an embodiment may be defined only by the second plate 262. The second plate 262 may extend in a direction toward the distal end of the electronic device 200 (e.g., the +Y-axis direction) to define a sound output passage area 260A surrounding at least a portion of the sound output passage 245.

In an embodiment, the front surface of the second plate 262 may refer to the surface of the second plate 262 oriented in the positive Z-axis direction. The rear surface of the second plate 262 may refer to the surface of the second plate 262 oriented in the -Z-axis direction.

Referring to FIG. 6A, in an embodiment, a portion of the sound output passage 245 may be defined by the rear surface of the second plate 262. The display 210 may be disposed on the front surface of the second plate 262.

Referring to FIG. 6B, the sound output passage area 260A according to an embodiment may be defined only by the first plate 261. The first plate 261 may extend in a direction toward the distal end of the electronic device 200 (e.g., the +Y-axis direction) to define the sound output passage area 260A surrounding at least a portion of the sound output passage 245.

In an embodiment, the front surface of the first plate 261 may refer to the surface of the first plate 261 oriented in the positive Z-axis direction. The rear surface of the first plate 261 may refer to the surface of the first plate 261 oriented in the -Z-axis direction.

Referring to FIG. 6B, in an embodiment, a portion of the sound output passage 245 may be defined by the rear surface of the first plate 261. The display 210 may be disposed on the front surface of the first plate 261.

In an embodiment, when the sound output passage area 260A is defined by only one plate (e.g., the first plate 261 or the second plate 262), the sound output passage 245 can be provided larger than that obtained when the sound output passage area 260A is defined by two plates 261 and 262. In the electronic device 200 according to an embodiment, since the sound output passage 245 can be provided larger, sound S can be propagated more easily along the sound output passage 245.

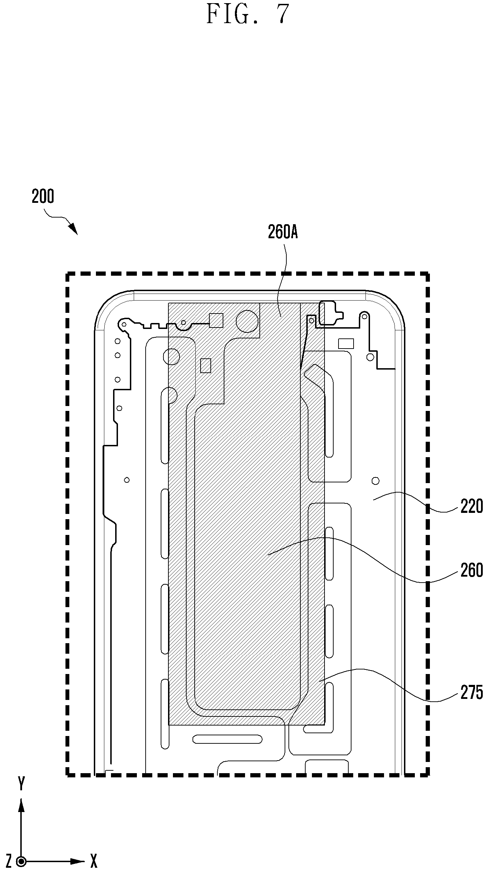

FIG. 7 is a view illustrating a support part 220, a heat transfer unit 260, and a thermal diffusion member 275 according to an embodiment of the disclosure.

In FIG. 7, some of the components of the electronic device 200 illustrated in FIG. 2 may be omitted.

Referring to FIG. 7, the support 220 may extend in the width direction of the electronic device 200 (e.g., the X-axis direction) and the length direction of the electronic device 200 (e.g., the Y-axis direction). The support 220 may serve to support other components of the electronic device 200.

In an embodiment, the heat transfer unit 260 may be disposed on the support 220. Referring to FIG. 7, the heat transfer unit 260 may be disposed on a portion of the support unit 220.

In an embodiment, the heat transfer unit 260 may extend in the width direction of the electronic device 200 (e.g., the X-axis direction) and the length direction of the electronic device 200 (e.g., the Y-axis direction). For example, the heat transfer unit 260 may extend in the length direction of the electronic device 200 (e.g., in the Y-axis direction) from the distal end of the electronic device 200 (e.g., the distal end of the electronic device 200 oriented in the +Y-axis direction).

In an embodiment, the heat transfer unit 260 may extend to a position overlapping the sound output module 240 (see FIG. 2) and the sound output passage 245 (see FIG. 2). For example, the heat transfer unit 260 may extend to include a sound output passage area 260A that overlaps the sound output passage 245 (see FIG. 2). The sound output passage area 260A may be an area that surrounds at least a portion of the sound output passage 245 (see FIG. 2) through which the sound S (see FIG. 2) generated by the sound output module 240 (see FIG. 2) is propagated.

In an embodiment, since the electronic device 200 is configured such that a portion of the sound output passage 245 (see FIG. 2) is surrounded by the heat transfer unit 260, a separate plate to define the sound output passage 245 (see FIG. 2) may not be necessary.

In an embodiment, the thermal diffusion member 275 may be disposed on the heat transfer unit 260. For example, the thermal diffusion member 275 may be disposed on the surface of the heat transfer unit 260 opposite to the surface facing the support 220.

In an embodiment, the thermal diffusion member 275 may be disposed to cover the heat transfer unit 260.

Referring to FIG. 7, the thermal diffusion member 275 according to an embodiment may be disposed to completely cover one surface of the heat transfer unit 260. The arrangement of the thermal diffusion member 275 illustrated in FIG. 7 is exemplary, and the thermal diffusion member 275 according to an embodiment may be disposed to cover a portion of one surface of the heat transfer unit 260.

In an embodiment, the thermal diffusion member 275 may serve to improve the heat transfer effect obtained via the heat transfer unit 260.

The electronic device may include a sound output module configured to output sound and a sound output passage through which sound generated by the sound output module passes.

Because the display may be made of a relatively fragile material, the electronic device may include a plate provided separately from the display to define a sound output passage through which sound passes. For example, at least a portion of the sound output passage may be defined by a separate plate made of stainless steel. When a separate plate defines a portion of the sound output passage, the manufacturing cost of the electronic device may increase.

An electronic device 200 may include a support bracket 221, a display 210 disposed on the front surface of the support bracket 221, a printed circuit board 230 disposed on the rear surface of the support bracket 221, a sound output module 240, an electronic component 250 disposed on the printed circuit board 230 and generating heat during operation, and a heat transfer unit 260 disposed between the display 210 and the support bracket 221 and configured to transfer the heat generated from the electronic component 250.

In an embodiment, the heat transfer unit 260 may be configured to provide a portion of a sound output passage 245 through which sound S generated from the sound output module 240 is propagated.

In the electronic device 200 according to an embodiment of the disclosure, the sound output passage 245 through which the sound S passes may be provided by extending a portion of the heat transfer unit 260.

The electronic device 200 according to an embodiment of the disclosure does not require a separate plate to provide the sound output passage 245 through which the sound S passes. Thus, the manufacturing cost of the electronic device 200 can be reduced, and the manufacturing process can be simplified because the sound output passage does not require a separate plate.

In an embodiment, the heat transfer unit 260 may include a vapor chamber including a first metal plate 261, a second metal plate 262, and a flow space 263 defined between the first metal plate 261 and the second metal plate 262.

In an embodiment, the vapor chamber may include a rear surface configured to provide a portion of the sound output passage and a front surface where the display 210 is disposed.

In an embodiment, the electronic component 250 may include a processor.

In an embodiment, a portion of the sound output passage 245 may be provided by the rear surface of the first metal plate 261.

In an embodiment, at least a portion of the display 210 may be disposed on the front surface of the first metal plate 261.

In an embodiment, a portion of the sound output passage 245 is provided by a rear surface of the second metal plate 262.

In an embodiment, at least a portion of the display 210 may be disposed on the front surface of the second metal plate 262.

In an embodiment, at least a portion of the flow space 263 may be disposed at a position overlapping the sound output passage 245.

In an embodiment, the heat transfer unit 260 may further include a support area 260B which is supported by the support bracket 221 and in which the first metal plate 261 and the second metal plate 262 are in contact with each other.

In an embodiment, the heat transfer unit 260 may include a diffusion material that is disposed inside the flow space 263 and is convertible into a liquid state and a gas state.

In an embodiment, the electronic device 200 may further include a heat transfer material 271 which is in contact with the electronic component 250 on one surface and is in contact with the heat transfer unit 260 on the other surface.

In an embodiment, the heat generated from the electronic component 250 may be transferred to the heat transfer unit 260 via the heat transfer material 271 which is comprised of thermal interface material.

In an embodiment, the electronic device 200 may further include an adhesive material 272 disposed between the support bracket 221 and the heat transfer unit 260 to couple the support bracket 221 and the heat transfer unit 260 to each other.

In an embodiment, the adhesive material 272 may seal a space between the support bracket 221 and the heat transfer unit 260.

In an embodiment, the electronic device 200 may further include a graphite sheet 275 disposed between the heat transfer unit 260 and the display 210.

In an embodiment, the electronic device 200 may further include a battery 280 disposed on the rear surface of the support bracket 221.

In an embodiment, the sound output module 240, the electronic component 250, and the battery 280 are arranged in that order along a length direction of the electronic device 200.

In an embodiment, the heat transfer unit 260 may extend from a position overlapping the sound output module 240 to a position overlapping the battery 280.

An electronic device 200 according to an embodiment of the disclosure may include a support bracket 221, a display 210 disposed on the front surface of the support bracket 221, an electronic component 250 generating heat during operation, and a heat transfer unit 260 disposed between the display 210 and the support bracket 221 and configured to transfer the heat generated from the electronic component 250. The heat transfer unit 260 may include plates 261 and 262 and a flow space 263 surrounded by the plates 261 and 262, and a portion of the plates 261 and 262 may provide a portion of a sound output passage 245 through which sound S is propagated.

In an embodiment, at least a portion of the flow space 263 may be disposed at a position overlapping a portion of the sound output passage 245.

In an embodiment, the electronic device 200 may further include an adhesive material 272 disposed between the support bracket 221 and the heat transfer unit 260 to couple the support bracket 221 and the heat transfer unit 260 to each other.

In an embodiment, the plates 261 and 262 may include a first plate 261 that is at least partially in contact with the support bracket 221, and a second plate 262 that is coupled to the first plate 261.

In an embodiment, the sound output passage 245 may be defined by the rear surface of the first plate 261.

In an embodiment, the sound output passage 245 may be defined by the rear surface of the second plate 262.

In an embodiment, the heat transfer unit 260 may further include a support area 260B which is supported by the support bracket 221 and does not include the flow space 263.

In an embodiment, the electronic device 200 may include a graphite sheet 275 disposed between the heat transfer unit 260 and the display 210.

The technical problems to be addressed by the disclosure are not limited to those described above, and other technical problems, which are not described above, may be clearly understood by a person ordinarily skilled in the related art, to which the disclosure belongs.

The effects that are capable of being obtained by the disclosure are not limited to those described above, and other effects not described above may be clearly understood by a person ordinarily skilled in the art to which the disclosure belongs.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (200) comprising:
a support bracket (221);
a display (210) disposed on a front surface of the support bracket (221);
a printed circuit board (230) disposed on a rear surface of the support bracket (221);
a sound output module (240);
an electronic component (250) disposed on the printed circuit board (230) and generating heat during operation; and
a heat transfer unit (260) disposed between the display (210) and the support bracket (221) and configured to transfer the heat generated from the electronic component (250),
wherein the heat transfer unit (260) is configured to provide a portion of a sound output passage (245) through which sound (S) generated from the sound output module (240) passes.

2. The electronic device (200) of claim 1, wherein the heat transfer unit (260) comprises a vapor chamber comprising a first metal plate (261), a second metal plate (262), and a flow space (263) formed between the first metal plate (261) and the second metal plate (262), and
wherein the vapor chamber comprises a rear surface configured to provide a portion of the sound output passage (245) and a front surface where the display (210) is disposed.

3. The electronic device (200) of claim 2, wherein a portion of the sound output passage (245) is provided by a rear surface of the first metal plate (261), and
wherein at least a portion of the display (210) is disposed on a front surface of the first metal plate (261).

4. The electronic device (200) of claim 2, wherein a portion of the sound output passage (245) is provided by a rear surface of the second metal plate (262), and
wherein at least a portion of the display (210) is disposed on a front surface of the second metal plate (262).

5. The electronic device of claim 2, wherein at least a portion of the flow space is formed at a location overlapping the sound output passage.

6. The electronic device (200) of any of claims 2 to 5, wherein the heat transfer unit (260) further comprises a support area (260B) which is supported by the support bracket (221) and in which the first metal plate (261) and the second metal plate (262) are in contact with each other.

7. The electronic device (200) of any of claims 2 to 6, wherein the heat transfer unit (260) further comprises a diffusion material that is disposed inside the flow space (263) and is convertible into a liquid state and a gas state.

8. The electronic device (200) of any of claims 1 to 7, further comprising:
a heat transfer material (271) that is in contact with the electronic component (250) on one surface and in contact with the heat transfer unit (260) on aother surface,
wherein the heat generated from the electronic component (250) is transferred to the heat transfer unit (260) via the thermal interface material.

9. The electronic device (200) of any of claims 1 to 8, further comprising:
an adhesive material (272) disposed between the support bracket (221) and the heat transfer unit (260) to couple the support bracket (221) and the heat transfer unit (260) to each other,
wherein the adhesive material (272) seals a space between the support bracket (221) and the heat transfer unit (260).

10. The electronic device (200) of any of claims 1 to 9, further comprising:
a graphite sheet (275) disposed between the heat transfer unit (260) and the display (210).

11. The electronic device (200) of any of claims 1 to 10, further comprising:
a battery (280) disposed on the rear surface of the support bracket (221),
wherein the sound output module (240), the electronic component (250), and the battery (280) are arranged in that order along a length direction of the electronic device (200), wherein the heat transfer unit (260) extends from a position overlapping the sound output module (240) to a position overlapping the battery (280).

12. An electronic device (200) comprising:
a support bracket (221);
a display (210) disposed on a front surface of the support bracket (221);
an electronic component (250) that generate heat during operation; and
a heat transfer unit (260) disposed between the display (210) and the support bracket (221) and configured to dissipate heat generated from the electronic component (250),
wherein the heat transfer unit comprises:
a plate; and
a flow space (263) surrounded by the plate, and
wherein at least a portion of the plate is configured to provide a portion of a sound output passage (245) through which sound (S) is propagated.

13. The electronic device of claim 12, wherein at least a portion of the flow space is disposed at a position overlapping the sound output passage.

14. The electronic device (200) of claim 12, further comprising:
an adhesive material (272) disposed between the support bracket (221) and the heat transfer unit (260) to bond the support bracket (221) and the heat transfer unit (260) to each other,
wherein the adhesive material (272) seals a space between the support bracket (221) and the heat transfer unit (260).

15. The electronic device (200) of any of claims 12 to 14, wherein the plate comprises:
a first plate (261) that is at least partially in contact with the support bracket (221); and
a second plate (262) that is coupled to the first plate (261), and
wherein the sound output passage (245) is defined by a rear surface of the first plate (261) or a rear surface of the second plate (262).
